(19) Europäisches Patentamt / European Patent Office / Office européen des brevets

(11) **EP 2 984 714 B1**

(12) **FASCICULE DE BREVET EUROPEEN**

(45) Date de publication et mention de la délivrance du brevet:
**26.12.2018 Bulletin 2018/52**

(21) Numéro de dépôt: **14717441.1**

(22) Date de dépôt: **10.04.2014**

(51) Int Cl.:
*H01S 5/042* *(2006.01)*     *H05K 1/18* *(2006.01)*
*H05K 1/02* *(2006.01)*     *H03K 3/57* *(2006.01)*

(86) Numéro de dépôt international:
**PCT/EP2014/057306**

(87) Numéro de publication internationale:
**WO 2014/167068 (16.10.2014 Gazette 2014/42)**

(54) **ORGANE DE PILOTAGE D'AU MOINS UNE DIODE**

VORRICHTUNG ZUR STEUERUNG MINDESTENS EINER DIODE

DEVICE FOR CONTROLLING AT LEAST ONE DIODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.04.2013  FR 1353242**

(43) Date de publication de la demande:
**17.02.2016  Bulletin 2016/07**

(73) Titulaire: **Brightloop**
**75020 Paris (FR)**

(72) Inventeurs:
• **LIFFRAN, Florent**
**75009 Paris (FR)**

• **RABOT, Olivier**
**94550 Chevilly-larue (FR)**

(74) Mandataire: **Lavialle, Bruno François Stéphane et al**
**Cabinet Boettcher**
**16, rue Médéric**
**75017 Paris (FR)**

(56) Documents cités:
**US-A- 5 736 881      US-A1- 2004 090 758**
**US-A1- 2009 059 981      US-A1- 2011 043 790**

**Description**

L'invention concerne un organe de pilotage d'au moins une diode.

ARRIERE PLAN DE L'INVENTION

Les diodes laser sont aujourd'hui utilisées dans de très nombreuses et très diverses applications de différents domaines industriels. On trouve par exemple des diodes laser dans des applications médicales (diagnostic, thérapie photodynamique, etc.), dans le domaine des télécommunications (émission de signaux optiques véhiculés dans une fibre optique), dans le domaine de la télémétrie, etc.

Le courant d'alimentation d'une diode laser, c'est-à-dire le courant parcourant la diode entre une anode et une cathode de celle-ci, peut varier, selon les applications, entre quelques milliampères et plusieurs centaines d'ampères. La diode laser est pilotée par un organe de pilotage (généralement désigné par le terme « driver ») dimensionné principalement en fonction du courant d'alimentation requis dans l'application. Un tel organe de pilotage comporte classiquement et non exhaustivement des moyens d'alimentation fournissant une énergie électrique utilisée pour alimenter les composants de l'organe de pilotage et pour générer le courant d'alimentation de la diode laser, un module de régulation de courant adapté à réguler le courant d'alimentation de la diode laser, des moyens de limitation pour limiter le courant d'alimentation de la diode laser de manière à protéger celle-ci, parfois une photodiode produisant un courant sensiblement proportionnel à l'intensité lumineuse générée par la diode laser, et utilisée pour vérifier le bon fonctionnement de l'organe de pilotage et éventuellement pour réguler le courant d'alimentation de la diode laser, etc.

Le rendement énergétique de l'ensemble formé par un organe de pilotage et une diode laser est un paramètre décisif dans de nombreuses applications, en particulier dans les applications portatives dans lesquelles l'organe de pilotage est alimenté par une batterie dont la capacité est limitée. On tente généralement, pour améliorer le rendement dudit ensemble, d'améliorer la structure interne des diodes (on tente par exemple de réduire des pertes optiques dues à des absorptions de photons par des porteurs de charges libres de manière à réduire le courant d'alimentation des diodes), ou bien de concevoir des modules de régulation de courant plus efficaces.

Il est ainsi possible d'améliorer le rendement dudit ensemble, mais cette amélioration s'accompagne généralement d'efforts de développement coûteux et/ou d'évolutions de schémas électriques tendant à complexifier l'organe de pilotage.

Un exemple d'organe de pilotage d'une diode laser ou électroluminescente est divulguée dans US2009/0059981 A1 (5.03.2009).

OBJET DE L'INVENTION

L'invention a pour objet un organe de pilotage d'au moins une diode permettant d'améliorer significativement le rendement d'un ensemble formé par l'organe de pilotage et par la diode, cette amélioration de rendement n'étant pas accompagnée des inconvénients précités.

RESUME DE L'INVENTION

L'invention est définit par les caractéristiques techniques de la revendication 1. Des modes de réalisation préférentiels sont divulgués dans les revendications dépendantes.

En vue de la réalisation de ce but, on propose un organe de pilotage d'au moins une diode, l'organe de pilotage comportant une carte électrique à laquelle est connectée la diode, ladite carte électrique comprenant un circuit imprimé sur lequel sont montés :

- un module de régulation de courant adapté à réguler un courant d'alimentation traversant la diode, le module de régulation de courant comprenant un composant frontal monté en série avec la diode;
- un condensateur de stockage monté en parallèle de la diode et du composant frontal, le condensateur de stockage étant utilisé pour stocker une certaine quantité d'énergie électrique d'alimentation, le courant d'alimentation provenant au moins partiellement de cette énergie électrique d'alimentation ;

la diode, le composant frontal et le condensateur de stockage étant connectés de manière à former une boucle de circuit s'étendant sensiblement dans une épaisseur de la carte électrique,
l'organe de pilotage étant caractérisé en ce que le condensateur de stockage (9) présente une valeur de capacité choisie pour que le condensateur de stockage forme un circuit résonant avec des éléments inductifs parasites (15) de la boucle de circuit (17).

La boucle ainsi formée s'étend dans un plan sensiblement transversal de la carte et présente une surface relativement faible diminuant une inductance d'éléments inductifs parasites de la boucle de circuit. En réduisant l'inductance des éléments inductifs parasites de la boucle de circuit, on réduit une tension d'entrée aux bornes du condensateur de stockage nécessaire pour obtenir une variation d'un courant d'alimentation de la diode suffisamment rapide et importante pour que la diode génère des impulsions lumineuses d'intensité et de durée souhaitée. On augmente ainsi le rendement de l'ensemble formé par la diode et par l'organe de pilotage, sans introduire de modifications complexes dans les schémas électriques de l'organe de pilotage et sans modifier la diode.

L'invention sera mieux comprise à la lumière de la description qui suit d'un mode de mise en oeuvre particulier non limitatif de l'invention.

BREVE DESCRIPTION DES DESSINS

Il sera fait référence aux dessins annexés, parmi lesquels :

- la figure 1 représente une carte électrique d'un organe de pilotage de l'invention ;
- la figure 2 représente un schéma électrique partiel de ladite carte électrique;
- la figure 3 représente schématiquement une face d'un circuit imprimé d'une carte électrique d'un organe de pilotage de l'art antérieur.

DESCRIPTION DETAILLEE DE L'INVENTION

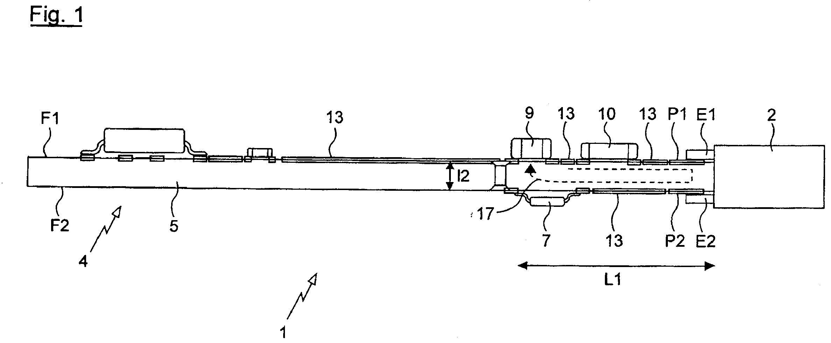

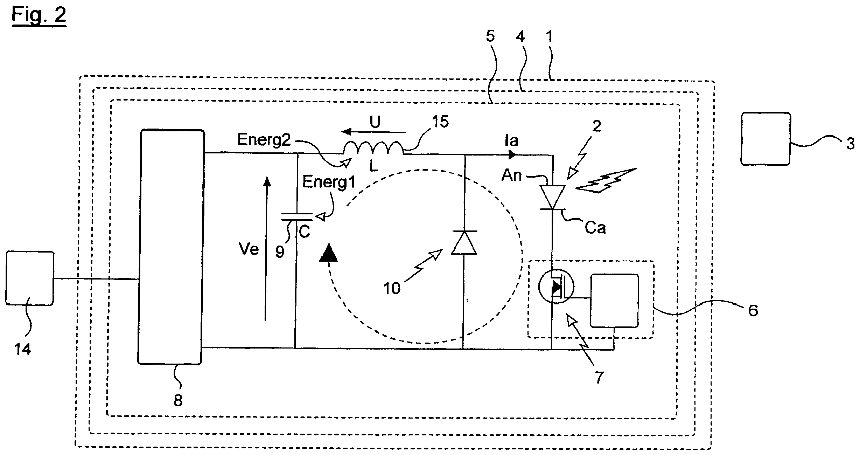

En référence aux figures 1 et 2, l'organe de pilotage 1 de l'invention est adapté à piloter une diode laser 2 utilisée pour émettre des signaux lumineux à destination d'un récepteur quelconque 3 bien connu par ailleurs et dont les caractéristiques ne seront pas décrites ici. Les signaux lumineux que l'organe de pilotage 1 et la diode laser 2 visent ici à produire sont des impulsions lumineuses très brèves et d'intensité lumineuse relativement importante.

Cet organe de pilotage 1 comporte une carte électrique 4 à laquelle est connectée la diode laser 2. La carte électrique 4 est constituée d'un circuit imprimé 5 éventuellement verni et d'un certain nombre de composants montés sur le circuit imprimé 5. Parmi ces composants, on trouve :

- des composants constituant un module de régulation de courant 6, de type régulateur linéaire, parmi lesquels un composant frontal, ici un transistor 7 de type MOSFET (pour « Métal Oxide Semiconductor Field Effect Transistor ») ;
- des moyens d'alimentation 8 ;
- un condensateur de stockage 9 (ou bien plusieurs condensateurs de stockage montés en parallèle) ;
- une diode de roue libre 10 ;
- d'autres composants divers, parmi lesquels des composants utilisés pour limiter le courant parcourant la diode laser, une photodiode, etc.

La diode laser 2, le régulateur linéaire 6, le transistor 7 de type MOSFET, les moyens d'alimentation 8, le condensateur de stockage 9, la diode de roue libre 10 sont connectés électriquement les uns aux autres conformément au schéma électrique représenté à la figure 2.

La diode laser 2 est ici une diode laser fonctionnant en mode dit mode QCW (pour « Quasi-Continuous Wave », que l'on traduira dans le présent texte par « Onde impulsionnelle »). La diode laser 2 comporte une anode An dite « anode principale » et une cathode Ca dite « cathode principale ». L'anode principale et la cathode principale sont les jonctions anode et cathode externes de la diode laser 2. L'anode principale An et la cathode principale Ca sont reliées respectivement à un premier élément de connexion E1 et à un deuxième élément de connexion E2 de la diode laser 2. Par élément de connexion, on entend ici tout élément conducteur de composant électrique adapté à être fixé sur une plage d'un circuit imprimé, par brasage notamment, de manière à connecter le composant électrique au circuit imprimé. Dans le cas de la diode laser 2, les éléments de connexion E1, E2 sont des broches de raccordement ou pattes. Ici, le premier et le deuxième élément de connexion E1, E2 de la diode laser 2 sont connectés respectivement à une première plage P1 d'une première face F1 du circuit imprimé 5 et à une deuxième plage P2 d'une deuxième face F2 du circuit imprimé 5.

Le transistor 7 du régulateur linéaire 6 est monté en série avec la diode laser 2. Le rôle du régulateur linéaire 6 est de contrôler un courant d'alimentation Ia de la diode laser 2 et, plus précisément, d'assurer que le courant d'alimentation Ia possède des caractéristiques permettant à la diode laser 2 de générer les impulsions lumineuses souhaitées. Ici, le courant d'alimentation Ia doit être constitué d'impulsions de courant de forte intensité (jusqu'à 1000 ampères), de durée très courte (de quelques microsecondes à quelques nanosecondes). Le transistor 7 est monté sur la deuxième face F2 du circuit imprimé 5.

Les moyens d'alimentation 8, eux-mêmes reliés à une alimentation 14 externe à l'organe de pilotage 1, fournissent une énergie électrique utilisée pour alimenter les composants de l'organe de pilotage 1 et pour générer le courant d'alimentation Ia de la diode laser 2.

Le condensateur de stockage 9, présentant une capacité C, permet de stocker une énergie électrique d'alimentation Energ1 de laquelle provient au moins partiellement le courant d'alimentation Ia (une partie du courant d'alimentation Ia peut éventuellement provenir directement des moyens d'alimentation 8). Le condensateur de stockage 9 est chargé par les moyens d'alimentation 8 entre chaque impulsion de courant. Il est possible éventuellement de connecter au condensateur de stockage 9 un composant de type chargeur de condensateur (non représenté ici), qui permet d'accélérer la charge du condensateur de stockage 9. Le condensateur de stockage 9 est monté sur la première face F1 du circuit imprimé 5.

On note sur le schéma électrique de l'organe de pilotage 1 de la figure 2 la présence d'éléments inductifs parasites 15 symbolisés par une inductance L présentant une borne reliée au condensateur de stockage 9 et une borne reliée à la diode de roue libre 10 et à la diode laser 2. Ces éléments inductifs parasites 15 sont issus de caractéristiques physiques des pistes 13 du circuit imprimé 5 et du circuit imprimé 5 lui-même.

Bien que l'ensemble des pistes 13 soit associé à de tels éléments inductifs parasites, les éléments inductifs parasites 15 représentés sont ceux qui ont la plus grande influence sur le fonctionnement de l'organe de pilotage 1 de la diode laser 2.

A la fin d'une impulsion du courant d'alimentation Ia, l'intensité de ce courant d'alimentation Ia passe brusquement d'une valeur très importante (jusqu'à 1000 ampères) à une valeur nulle, ce qui tend à générer aux bornes des éléments inductifs parasites 15 une surtension importante susceptible d'endommager la diode laser 2 et le transistor 7. L'énergie dont est issue cette surtension est une énergie Energ2 emmagasinée dans les éléments inductifs parasites 15. En devenant passante à la fin de l'impulsion de courant d'alimentation, la diode de roue libre 10 limite la surtension et dérive le courant d'alimentation Ia vers le condensateur de stockage 9 permettant ainsi de récupérer une partie de l'énergie emmagasinée Energ2. La diode de roue libre 10 est montée sur la première face F1 du circuit imprimé 5.

Comme cela est visible à la figure 2, le condensateur de stockage 9, la diode laser 2 et le transistor 7 sont reliés entre eux de manière à former une boucle de circuit 17 (par boucle de circuit, on entend ici un certain ensemble de composants ainsi que les pistes ou autre conducteurs reliant ces composants, le certain ensemble de composants étant tel que chaque composant comporte deux éléments de connexion dits éléments de boucle, chacun des deux éléments de boucle de chaque composant étant relié à une seul élément de boucle d'un composant différent de la boucle).

Les éléments inductifs parasites 15 sont donc inclus dans la boucle de circuit 17.

Il est fondamental, au cours de la conception de l'organe de pilotage 1, de limiter autant que possible la valeur d'inductance L des éléments inductifs parasites 15. En effet, en application de la relation U = L. dI/dt (valable pour une bobine inductive présentant une résistance nulle et donc bien sûr applicable de manière très approximative à la présente situation), où U est la tension aux bornes des éléments inductifs parasites, I le courant les parcourant et sensiblement égal au courant d'alimentation Ia lorsque la diode de roue libre 10 est bloquée, il apparaît que, pour obtenir une variation de courant très importante et très rapide sans augmenter une tension d'entrée Ve aux bornes du condensateur de stockage 9 de manière démesurée, il est nécessaire de réduire autant que possible la valeur de l'inductance L.

On sait que dans une boucle de circuit telle la boucle 17, l'inductance L des éléments inductifs parasites 15 est sensiblement proportionnelle au rapport S/e, où S est la surface de la boucle et e est l'épaisseur de la boucle.

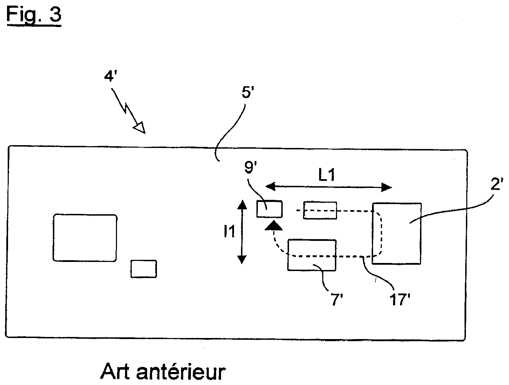

Dans un organe de pilotage classique, dont une carte électrique 4' est représentée schématiquement à la figure 3, comportant un condensateur de stockage 9', une diode laser 2', un transistor 7' d'un régulateur linéaire, montés sur une même première face F1' d'un circuit imprimé 5', l'inductance des éléments parasites inductifs d'une boucle de circuit 17' formée par ces composants et ces pistes est proportionnelle à S'/e', soit à $L1.l1/e1$, où L1 et l1 sont respectivement la longueur et la largeur d'une surface rectangulaire du circuit imprimé 5' sur laquelle sont montés les composants précités, et e1 est l'épaisseur des pistes du circuit imprimé. La boucle de circuit 17' s'étend ici dans un plan parallèle à la surface de la carte électrique 4'. On considère que la largeur d'un élément de connexion de la diode laser 7' est une bonne estimation de l1. On utilisera pour évaluer S'/e' les valeurs suivantes : L1 = 3 centimètres, l1 = 2 centimètres, et e1 = 100 micromètres. On obtient S'/e'= 6 mètres.

Dans l'organe de pilotage 1 de l'invention, la diode laser 2, le transistor 7, le condensateur de stockage 9 et les pistes ou conducteurs reliant ces composants sont agencés de manière à ce que la boucle de circuit 17 ainsi formée s'étende dans un plan sensiblement transversal de la carte, et présente donc une surface relativement faible. Ici, la diode laser 2, le transistor 7 et le condensateur de stockage 9 sont montés de part et d'autre du circuit imprimé 5. Avantageusement, le condensateur de stockage 9 est monté très proche de la diode laser 2, et le condensateur de stockage 9 et le transistor 7 sont montés sensiblement en vis-à-vis l'un de l'autre par rapport au circuit imprimé 5.

En supposant que la longueur de la surface sur laquelle sont montés les composants est toujours égale à L1, on a ici une surface de boucle (visible à la figure 1) proportionnelle à $L1.l2/l1$, où l2 est l'épaisseur du circuit imprimé. On utilisera pour évaluer S/e les valeurs suivantes : L1 = 3 centimètres, l2 = 1,6 millimètres, et l1 = 2 centimètres. On obtient S/e = 2.4 millimètres.

On voit donc que le rapport (S'/e')/(S/e) est très important, égal ici à 2500 : on peut donc théoriquement réduire très fortement la valeur d'inductance des premiers éléments inductifs. Dans la pratique, l'amélioration obtenue est moins importante, et on observe que l'inductance est couramment réduite d'un rapport compris entre 5 et 50.

On note ici qu'une réduction d'inductance aurait aussi été obtenue si la diode laser 2, le transistor 7 et le condensateur de stockage 9 avaient été montés sur une même face du circuit imprimé 5, à condition que les pistes ou conducteurs reliant ces composants soient agencées de sorte que la boucle de circuit 17 ainsi formée s'étende dans un plan sensiblement transversal de la carte. Par exemple la réduction d'inductance est bien obtenue si lesdits composants sont montés sur une même face et connectés de sorte que la ou les pistes (ou autre type de conducteur) assurant le retour de courant soient réalisées sur l'autre face.

En réduisant fortement cette inductance L, on a réduit la tension d'entrée Ve aux bornes du condensateur de stockage 9 nécessaire pour obtenir le courant d'alimentation requis Ia, et on a donc augmenté le rendement de l'ensemble formé par l'organe de pilotage 1 et la 2 sans modifier la structure de la diode laser 2 ni les schémas électriques de l'organe de pilotage 1.

Avantageusement, on prévoit de dimensionner le condensateur de stockage 9 pour que celui-ci présente une valeur de capacité C telle que le condensateur de stockage 9 forme un circuit résonant avec les éléments inductifs parasites 15 de la boucle de circuit 17. La fréquence de résonnance fo choisie pour ce circuit de résonance est alors telle que :

$$fo = \frac{1}{2.\pi.\sqrt{L.C}} = \frac{1}{2.To},$$

L étant la valeur d'inductance des éléments inductifs parasites 15, C la valeur de capacité du condensateur de stockage 9, et To la durée moyenne d'une impulsion de courant. La fréquence de résonance fo est ainsi sensiblement égale à l'inverse du double de la durée d'une impulsion de courant.

Ainsi, au moment où une impulsion du courant d'alimentation s'achève et où la diode de roue libre 10 devient passante, le courant circulant depuis les éléments inductifs parasites 15 vers le condensateur de stockage 9 via la diode de roue libre 10 est maximal, ce qui permet d'optimiser la charge du condensateur de stockage 9 et donc la récupération de l'énergie électrique emmagasinée Energ2 contenue dans les éléments inductifs parasites 15.

La récupération de cette énergie électrique emmagasinée Energ2 permet d'augmenter à nouveau le rendement énergétique de l'organe de pilotage.

L'invention n'est pas limitée au mode de réalisation particulier qui vient d'être décrit, mais, bien au contraire, couvre toute variante entrant dans le cadre de l'invention telle que définie par les revendications.

Bien que l'on ait donné un certain nombre de valeurs numériques, celles-ci sont bien sûr fournies à titre illustratif et peuvent varier de façon importante dans une application mettant en oeuvre l'invention.

L'organe de pilotage de l'invention peut bien sûr être utilisé pour piloter une diode de technologie différente, et notamment une diode électroluminescente. L'organe de pilotage est de plus adapté à piloter une diode laser ou une diode électroluminescente, quelle que soit la longueur d'onde d'émission de ladite diode. Il peut aussi être utilisé pour piloter plusieurs diodes, par exemple montées en série.

Bien que l'on ait indiqué que le module de régulation de courant 6 est un régulateur linéaire, c'est-à-dire que le transistor 7 est commandé pour fonctionner en régime linéaire, il est bien sûr parfaitement possible de commander le transistor 7 pour qu'il fonctionne en régime saturé (commutation).

**Revendications**

1. Organe de pilotage d'au moins une diode laser ou électroluminescente (2), l'organe de pilotage comportant une carte électrique (4) à laquelle est connectée la diode (2), ladite carte électrique (4) comprenant un circuit imprimé (5) sur lequel sont montés :

- un module de régulation de courant (6) adapté à réguler un courant d'alimentation traversant la diode (2), le module de régulation de courant comprenant un composant frontal (7) monté en série avec la diode (2) ;
- un condensateur de stockage (9) monté en parallèle de la diode (2) et du composant frontal (7), le condensateur de stockage (9) étant utilisé pour stocker une certaine quantité d'énergie électrique d'alimentation (Energ1), le courant d'alimentation provenant au moins partiellement de cette énergie électrique d'alimentation ;

la diode (2), le composant frontal (7) et le condensateur de stockage (9) étant connectés de manière à former une boucle de circuit (17) s'étendant sensiblement dans une épaisseur de la carte électrique (4),
l'organe de pilotage étant **caractérisé en ce que** le condensateur de stockage (9) présente une valeur de capacité choisie pour que le condensateur de stockage forme un circuit résonant avec des éléments inductifs parasites (15) de la boucle de circuit (17).

2. Organe de pilotage selon la revendication 1, dans lequel la diode (2), le composant frontal (7) et le condensateur de stockage (9) sont répartis sur deux faces opposées de la carte électrique (4).

3. Organe de pilotage selon l'une des revendications précédentes comprenant en outre une diode de roue libre (10) montée en parallèle du condensateur de stockage (9), la diode de roue libre (10) étant destinée à évacuer vers le condensateur de stockage (9), lorsque le module de régulation (6) annule le courant d'alimentation, une énergie électrique emmagasinée (Energ2) dans les éléments inductifs parasites (15) de la boucle de circuit (17).

4. Organe de pilotage selon l'une des revendications précédentes, dans lequel la diode (2) comporte une anode (An), une cathode (Ca), un premier élément de connexion (E1) relié à l'anode et connecté à une première face (F1) du circuit imprimé (5), et un deuxième élément de connexion (E2) relié à la cathode et connecté à une deuxième face (F2) du circuit imprimé (5).

5. Organe de pilotage selon l'une des revendications précédentes, dans lequel le condensateur de stockage (9) et le composant frontal (7) sont montés sensiblement en vis-à-vis l'un de l'autre par rapport au circuit imprimé (5).

6. Organe de pilotage selon l'une des revendications précédentes, dans lequel le composant frontal (7) du module de régulation de courant (6) est un transistor commandé en régime saturé.

7. Organe de pilotage selon l'une des revendications 1 à 5, dans lequel le module de régulation (6) est un régulateur linéaire et le composant frontal (7) est un transistor.

8. Organe de pilotage selon la revendication 1, le module d'alimentation étant adapté à générer des impulsions de courant d'alimentation d'une certaine durée (To) pour que la diode émette des impulsions lumineuse, le circuit résonant présentant une fréquence de résonance (fo) sensiblement égale à l'inverse du double de la certaine durée.

## Patentansprüche

1. Steuerorgan zur Steuerung mindestens einer Laser- oder Leuchtdiode (2), wobei das Steuerorgan eine elektrische Karte (4) umfasst, mit der die Diode (2) verbunden ist, wobei die elektrische Karte (4) eine gedruckte Schaltung (5) umfasst, auf der montiert sind:

- ein Stromregulierungsmodul (6), das dazu geeignet ist, einen die Diode (2) durchfließenden Versorgungsstrom zu regulieren, wobei das Stromregulierungsmodul ein Frontbauteil (7) umfasst, das mit der Diode (2) in Reihe geschaltet ist;
- ein Speicherkondensator (9), der zur Diode und zum Frontbauteil (7) parallel geschaltet ist, wobei der Speicherkondensator (9) verwendet wird, um eine bestimmte Menge an elektrischer Versorgungsenergie (Energ1) zu speichern, wobei der Versorgungsstrom zumindest teilweise aus dieser elektrischen Versorgungsenergie stammt;

wobei die Diode (2), das Frontbauteil (7) und der Speicherkondensator (9) verbunden sind, um eine Stromkreisschleife (17) zu bilden, die sich im Wesentlichen in einer Dicke der elektrischen Karte (4) erstreckt, wobei das Steuerorgan **dadurch gekennzeichnet ist, dass** der Speicherkondensator (9) einen Kapazitätswert aufweist, der so gewählt ist, dass der Speicherkondensator einen Resonanzkreis mit den parasitären induktiven Elementen (15) der Stromkreisschleife (17) bildet.

2. Steuerorgan nach Anspruch 1, bei dem die Diode (2), das Frontbauteil (7) und der Speicherkondensator (9) auf zwei abgewandten Seiten der elektrischen Karte (4) verteilt sind.

3. Steuerorgan nach einem der vorhergehenden Ansprüche, ferner umfassend eine Freilaufdiode (10), die zum Speicherkondensator (9) parallel geschaltet ist, wobei die Freilaufdiode dazu bestimmt ist, wenn das Regulierungsmodul (6) den Versorgungsstrom aufhebt, eine elektrische Energie (Energ2), die in den parasitären induktiven Elementen (15) der Stromkreisschleife (17) gespeichert ist, in Richtung des Speicherkondensators (9) abzuführen.

4. Steuerorgan nach einem der vorhergehenden Ansprüche, bei dem die Diode (2) eine Anode (An), eine Kathode (Ca), ein erstes Verbindungselement (E1), das an die Anode angeschlossen und mit einer ersten Fläche (F1) der gedruckten Schaltung (5) verbunden ist, und ein zweites Verbindungselement (E2) umfasst, das an die Kathode angeschlossen und mit einer zweiten Fläche (F2) der gedruckten Schaltung (5) verbunden ist.

5. Steuerorgan nach einem der vorhergehenden Ansprüche, bei dem der Speicherkondensator (9) und das Frontbauteil (7) in Bezug auf die gedruckte Schaltung (5) im Wesentlichen einander gegenüberliegend angeordnet sind.

6. Steuerorgan nach einem der vorhergehenden Ansprüche, bei dem das Frontbauteil (7) des Stromregulierungsmoduls (6) ein Transistor ist, der im gesättigten Bereich gesteuert wird.

7. Steuerorgan nach einem der Ansprüche 1 bis 5, bei dem das Regulierungsmodul (6) ein linearer Regler und das Frontbauteil (7) ein Transistor ist.

8. Steuerorgan nach Anspruch 1, wobei das Versorgungsmodul dazu geeignet ist, Versorgungsstromimpulse mit einer bestimmten Dauer (To) zu erzeugen, damit die Diode Lichtimpulse aussendet, wobei der Resonanzkreis eine Resonanzfrequenz (fo) aufweist, die im Wesentlichen gleich dem Kehrwert des Doppelten der bestimmten Dauer ist.

## Claims

1. A driver member for driving at least one laser or light-emitting diode (2), the driver member comprising a circuit card (4) to which the diode (2) is connected, said circuit card (4) comprising a printed circuit (5) having the following mounted thereon:

• a current regulator module (6) adapted to regulate a power supply current passing through the diode (2), the current regulator module including an "end" component (7) connected in series with the diode (2); and
• a storage capacitor (9) connected in parallel with the diode (2) and the end component (7), the storage capacitor (9) being used for storing a certain quantity of power supply electrical energy (Energ1), the power supply current coming at least in part from this power supply electrical energy;

the diode (2), the end component (7), and the storage capacitor (9) being connected in such a manner as to form a circuit loop (17) extending substantially in a thickness of the circuit card (4), the driver member being **characterized in that** the storage capacitor (9) presents capacitance selected so that the storage capacitor co-operates with the stray inductor element (15) of the circuit loop (17) to form a resonant circuit.

2. The driver member according to claim 1, wherein the diode (2), the end component (7), and the storage capacitor (9) are distributed on two opposite faces of the circuit card (4).

3. The driver member according to any of the preceding claims, further including a freewheel diode (10) connected in parallel with the storage capacitor (9), the freewheel diode (10) acting when the regulator module switches off the power supply current, to divert electrical energy stored in stray inductor elements (15) of the circuit loop (17) to the storage capacitor (9).

4. The driver member according to any of the preceding claims, wherein the diode (2) has an anode (An), a cathode (Ca), a first connection element (E1) connected to the anode and connected to a first face (F1) of the printed circuit, and a second connection element (E2) connected to the cathode and connected to the second face (F2) of the printed circuit (5).

5. The driver member according to any of the preceding claims, wherein the storage capacitor (9) and the end component (7) are mounted substantially facing each other about the printed circuit (5).

6. The driver member according to any of the preceding claims, wherein the end component (7) of the current regulator module (6) is a transistor controlled under saturated conditions.

7. The driver member according to any one of claims 1 to 5, wherein the regulator module (6) is a linear regulator and the end component (7) is a transistor.

8. The driver member according to claim 1, in which the power supply module is adapted to generate power supply current pulses of a certain duration (To) so that the diode emits light pulses, and the resonant circuit presents a resonant frequency (fo) that is substantially equal to the reciprocal of twice that certain duration.

EP 2 984 714 B1

Fig. 1

Fig. 2

Fig. 3

Art antérieur

**EP 2 984 714 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090059981 A1